# DEMANDE DE BREVET EUROPEEN

(11) **EP 1 146 561 A1**
(43) Date de publication de la demande: **17.10.2001**
(21) Numéro de dépôt: 01410040.8
(22) Date de dépôt: 09.04.2001
(51) Int. Cl.: H01L 27/082

(54) **Procédé de réalisation d'un transistor bipolaire**

(30) Priorité: 10.04.2000 FR 0004588
(71) Demandeur: STMicroelectronics S.A., 92120 Montrouge (FR)
(72) Inventeur: Gris, Yvon, 38210 Tullins (FR); Schwartzmann, Thierry, 38480 Le Versoud (FR)
(74) Mandataire: de Beaumont, Michel

(57) **Abrégé**

L'invention concerne un procédé de réalisation d'un transistor bipolaire dans un substrat de type P comprenant les étapes consistant à former dans le substrat une première zone (3) de type N ; former par épitaxie une première couche de silicium (30) ; former dans cette première couche, et sensiblement au-dessus de la première zone, une deuxième zone (34) fortement dopée de type P, disjointe de la deuxième zone ; former en périphérie de cette deuxième zone une troisième zone (36) de type N ; former par épitaxie une deuxième couche de silicium (41) ; réaliser une tranchée profonde (50) traversant les première et deuxième couches de silicium, pénétrant dans le substrat et séparant latéralement la deuxième zone (34) de la troisième zone (36) ; et procéder à un recuit tel que le dopant de la troisième zone (36) soit en continuité avec celui de la première zone (3).

## Description

La présente invention concerne la fabrication de circuits intégrés et plus particulièrement la fabrication d'un transistor bipolaire de type PNP de caractéristiques optimisées ou la fabrication simultanée d'un transistor bipolaire de type NPN et d'un transistor bipolaire de type PNP ayant tous deux des caractéristiques optimisées. La présente invention est notamment compatible avec des techniques de fabrication de composants de type MOS complémentaires (CMOS) ou dans lesquelles on fabrique simultanément dans un même substrat semiconducteur des composants de type bipolaire et des composants de type MOS (BiCMOS).

En particulier, pour que des transistors bipolaires soient adaptés à fonctionner à haute fréquence, il faut minimiser leurs capacités parasites et leurs résistances internes, notamment la résistance de collecteur.

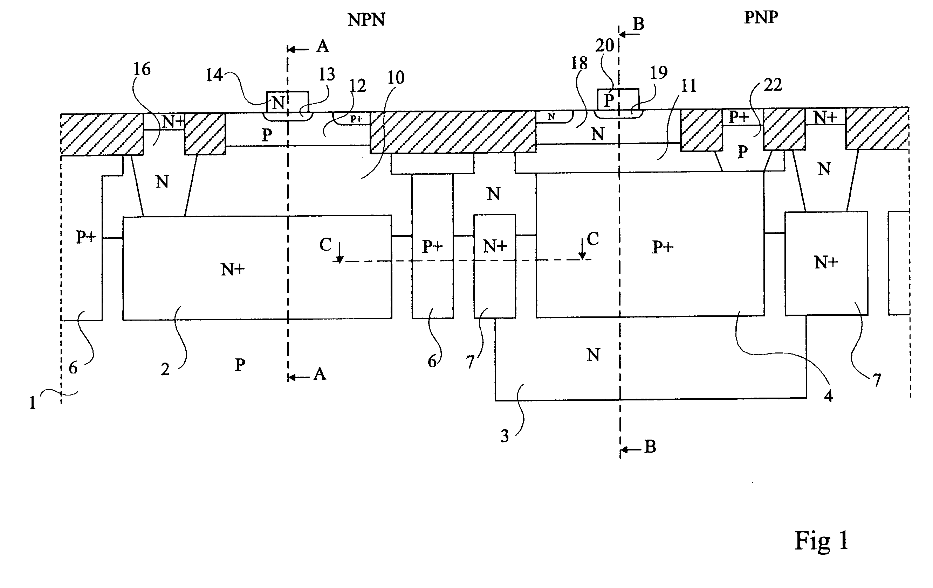

La figure 1 représente une structure classique associant un transistor bipolaire de type NPN et un transistor bipolaire de type PNP. Le transistor NPN est représenté du côté gauche de la figure et le transistor PNP du côté droit. La structure est formée à partir d'un substrat semiconducteur 1 de silicium monocristallin de type P. Dans ce substrat, on a réalisé diverses implantations. Une implantation de type N⁺ est destinée à former une région 2 correspondant au collecteur enterré du transistor NPN. Du côté du transistor PNP, une implantation de type N sert à définir une zone d'isolement de ce transistor et une implantation de type P⁺ est destinée à former une zone 4 de collecteur enterré. Une implantation d'isolement 6 de type P⁺ est formée à la périphérie du transistor NPN, cette implantation étant de préférence réalisée en même temps que celle destinée à former le collecteur 4 du transistor PNP. Une implantation 7 de type N⁺ est formée à la périphérie du transistor PNP, cette implantation étant de préférence réalisée en même temps que l'implantation de collecteur du transistor NPN.

Après cela, on a procédé à une étape d'épitaxie pour obtenir une couche faiblement dopée sur toute la surface du dispositif. Après traitement, cette couche est dopée de type N du côté du transistor NPN (référence 10) pour en constituer le collecteur et est dopée de type P (référence 11) du côté du transistor PNP pour en constituer le collecteur. Elle est de préférence dopée de type N à la périphérie du transistor PNP pour contribuer à son isolement. Du côté du transistor NPN, on a formé dans la couche épitaxiée 10 une région de base de type P 12 et une région d'émetteur de type N 13, par exemple par diffusion à partir d'une zone de silicium polycristallin 14. Un puits collecteur 16 est en contact avec la couche enterrée 2. Du côté du transistor PNP, on a formé dans la région 11 de type P une région de base de type N 18 dans laquelle on forme une région d'émetteur 19, par exemple par diffusion à partir d'une zone de silicium polycristallin dopée 20 de type P. De même que pour le transistor NPN, un puits collecteur 22 de type P vient prendre le contact avec la couche enterrée de collecteur 4.

Divers éléments des composants de la figure 1 n'ont pas été décrits, notamment les zones d'isolement de champ et de reprise de contact. Il s'agit en effet d'éléments classiques à la portée de l'homme du métier qui pourra se référer aux ouvrages usuels sur les semiconducteurs ou aux notices de la société STMicroelectronics.

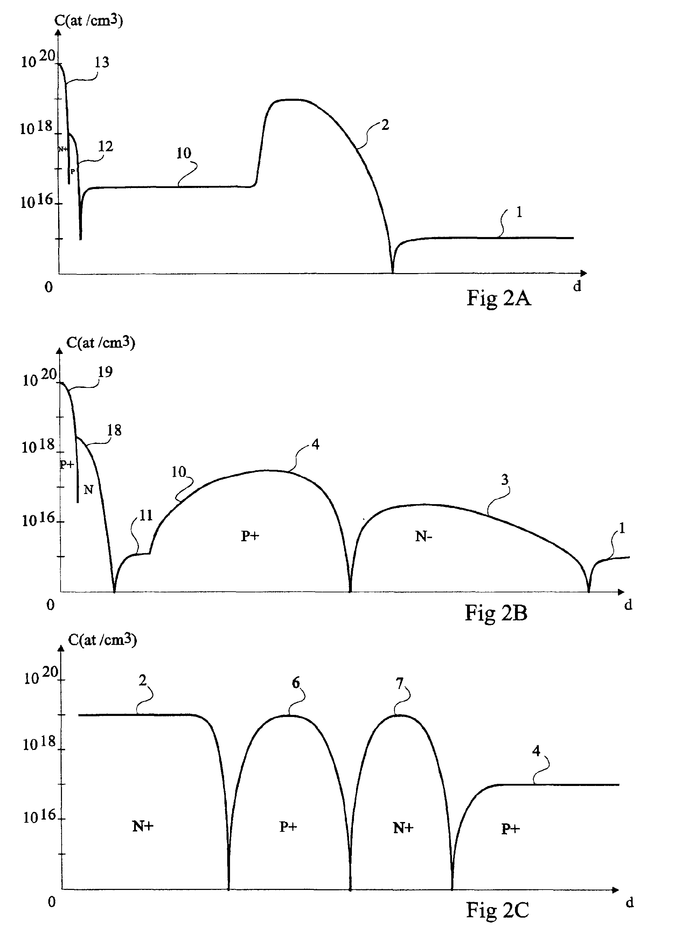

Les figures 2A, 2B et 2C représentent des courbes de concentration en atomes par cm³ en fonction de la distance d. La figure 2A correspond au plan de coupe AA pris dans le sens de la profondeur du côté du transistor NPN, la figure 2B correspond au plan de coupe BB dans le sens de la profondeur du côté du transistor PNP, et la figure 2C correspond au plan de coupe CC dans un sens transverse en allant de la couche enterrée de collecteur du transistor NPN à la couche enterrée de collecteur du transistor PNP. Dans ces figures, on a représenté pour chaque portion de courbe la référence de la couche correspondante.

On va décrire ces courbes pour montrer les compromis auxquels se trouve confronté l'homme de l'art pour optimiser simultanément les performances des transistors NPN et PNP.

Comme le représente la figure 2A, le collecteur du transistor NPN correspond à la région 10 qui est une portion d'une couche épitaxiée, éventuellement surdopée de façon appropriée, et à une région 2 qui correspond à une couche enterrée et qui sert à prendre le contact de collecteur verticalement par l'intermédiaire du puits collecteur 16. Pour optimiser le fonctionnement du transistor NPN, l'épaisseur correspondant à la portion de couche 10 doit être soigneusement choisie. Cette épaisseur qui est peu différente de l'épaisseur de la couche épitaxiée ne doit pas être trop faible pour que le transistor ait une tenue en tension satisfaisante. Elle doit toutefois être aussi faible que possible pour permettre au transistor de fonctionner à une fréquence élevée.

Si l'on considère maintenant le transistor PNP, en relation avec la figure 2B, plusieurs compromis délicats s'imposent. Notamment, il faut que le dopage de la couche d'isolement 3 soit suffisamment élevé. Etant donné que les dopants des couches 3 et 4 s'interpénètrent, pour que le dopage final de type P de la région 4 soit suffisamment élevé, on est amené à choisir un niveau d'implantation relativement élevé pour la couche P 4. Cette augmentation du niveau de dopage de la couche enterrée 4 a pour conséquence une compensation du dopage N de la région 3, le problème est donc difficilement soluble. De plus la région enterrée 4 a tendance à remonter de façon plus importante dans la couche épitaxiée 11. Pour qu'il reste une région de collecteur faiblement dopée 11 suffisante après les divers traitements thermiques, on est amené à choisir une couche épitaxiée plus épaisse que ce que l'on souhaiterait pour l'optimisation du transistor NPN décrite précédemment.

Si l'on se réfère à la figure 2C, on note qu'en fait au niveau de la coupe représentée, le niveau de dopage de la région d'isolement 6 va être plus élevé que le niveau de dopage de la couche enterrée 4. En effet, comme on l'a indiqué précédemment, les caractéristiques de la couche enterrée 4 résultent d'une compensation entre le dopage de type P souhaité et le dopage de type N de la couche d'isolement 3. Ainsi, la région 6 se trouve très fortement dopée, plus que ce que l'on souhaiterait, et ceci augmente la capacité parasite latérale entre le collecteur enterré 2 du transistor NPN et la couche d'isolement 6 qui se trouve être au potentiel du substrat. Ainsi, la capacité collecteur/ substrat du transistor NPN augmente, ce qui nuit à sa rapidité de fonctionnement et à sa consommation. Pour éviter les divers problèmes liés à ces capacités parasites, on comprendra en considérant la figure 2C que l'on est amené à écarter les unes des autres les implantations d'où résultent les couches enterrées 2, 6, 7 et 4. Il en résulte une augmentation de la surface occupée par les composants.

On se trouve donc comme on l'a indiqué précédemment inévitablement devant des compromis à réaliser quant au choix de l'épaisseur de la couche épitaxiée 10-11, au choix du niveau de dopage des régions enterrées de type P, et au choix du niveau de dopage de la couche d'isolement 3. On est par conséquent amené à des compromis notamment entre l'optimisation du transistor NPN et l'optimisation du transistor PNP.

Un objet de la présente invention est de prévoir une nouvelle structure de transistor PNP associable à un transistor NPN permettant d'optimiser simultanément les caractéristiques des transistors PNP et NPN, et un procédé de fabrication d'une telle structure.

Plus particulièrement, un objet de la présente invention est de prévoir un procédé permettant de sélectionner le niveau de dopage de la couche enterrée de type P de collecteur d'un transistor PNP de façon relativement indépendante des autres paramètres du transistor.

Un autre objet de la présente invention est de prévoir un tel procédé dans lequel on optimise la réalisation des couches d'isolement du transistor PNP.

Un autre objet de la présente invention est de prévoir un tel procédé permettant de réduire la capacité parasite collecteur-substrat du transistor NPN.

Un autre objet de la présente invention est de prévoir un tel procédé permettant d'associer un transistor NPN et un transistor PNP dans une surface de silicium réduite.

Un autre objet de la présente invention est de prévoir un tel procédé permettant la réalisation d'une nouvelle structure de transistor NPN à tenue en tension élevée.

Un autre objet de la présente invention est de prévoir un tel procédé permettant l'association de transistors bipolaires complémentaires et de transistors MOS complémentaires sur une surface réduite de silicium.

Pour atteindre ces objets, la présente invention prévoit un procédé de réalisation d'un transistor bipolaire dans un substrat d'un premier type de conductivité comprenant les étapes consistant à former dans le substrat une première zone d'un deuxième type de conductivité ; former par épitaxie une première couche de silicium ; former dans cette première couche de silicium, et sensiblement au-dessus de la première zone une deuxième zone fortement dopée, du premier type de conductivité, disjointe de la deuxième zone ; former en périphérie de cette deuxième zone une troisième zone du deuxième type de conductivité ; former par épitaxie une deuxième couche de silicium ; réaliser une tranchée profonde traversant les première et deuxième couches de silicium, pénétrant dans le substrat et séparant latéralement la deuxième zone de la troisième zone ; et procéder à un recuit tel que le dopant de la troisième zone soit en continuité avec celui de la première zone.

Selon un mode de réalisation de la présente invention, le premier type de conductivité est le type P et le deuxième type de conductivité est le type N, le transistor réalisé étant un transistor PNP, et le procédé comprend en outre la réalisation d'un transistor de type NPN pour lequel on forme dans la première couche de silicium une région fortement dopée de type N, la région correspondant au transistor NPN étant séparée de la région correspondant au transistor PNP par au moins une tranchée.

Selon un mode de réalisation de la présente invention, on forme en outre un transistor NPN dont la couche enterrée de collecteur correspond à ladite première zone.

La présente invention prévoit aussi un transistor bipolaire de type PNP réalisé dans deux couches successives épitaxiées sur un substrat de type P comprenant dans sa partie centrale une première zone N diffusée dans le substrat P, une deuxième zone P⁺ réalisée dans la première couche épitaxiée, une structure de base N et d'émetteur P⁺ réalisée dans la deuxième couche épitaxiée ; une tranchée en anneau creusée dans le silicium, traversant les deux couches épitaxiées et pénétrant dans le substrat, la deuxième zone étant délimitée latéralement par cet anneau, la première zone s'étendant au moins partiellement sous ledit anneau ; et à l'extérieur de l'anneau, une troisième zone N⁺ réalisée dans la première couche épitaxiée et venant en contact avec la première zone N.

Selon un mode de réalisation de la présente invention, le transistor bipolaire de type PNP comprend une deuxième tranchée traversant les deux couches de silicium épitaxiées et entourant la troisième zone N⁺.

Selon un mode de réalisation de la présente invention, un transistor bipolaire de type NPN comprend dans sa partie centrale une même première zone N, une quatrième zone N réalisée dans la première couche épitaxiée, une structure de base P et d'émetteur N⁺ réalisée dans la deuxième couche épitaxiée ; une tranchée en anneau creusée dans le silicium, traversant les deux couches épitaxiées et pénétrant dans le substrat, la quatrième zone étant délimitée latéralement par cet anneau, la première zone s'étendant au moins partiellement sous ledit anneau ; et à l'extérieur de l'anneau, une troisième zone N⁺ réalisée dans la première couche épitaxiée et venant en contact avec la première zone N.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 décrite précédemment représente une structure classique associant un transistor NPN et un transistor PNP ;
les figures 2A à 2C décrites précédemment sont des courbes de concentration en fonction de la profondeur selon diverses coupes de la structure de la figure 1 ;
les figures 3A à 3F sont des vues en coupe d'étapes successives d'un procédé de fabrication permettant de réaliser simultanément un transistor NPN et un transistor PNP selon la présente invention ;
les figures 4A à 4C sont des courbes de concentration en fonction de la distance prises selon les lignes A-A, B-B et C-C de la figure 3F ; et
la figure 5 est une vue en coupe d'une variante de transistor NPN selon la présente invention.

Comme cela est usuel dans le domaine de la représentation des circuits intégrés, les diverses couches et régions des diverses figures ne sont pas représentées à l'échelle pour faciliter la compréhension. Dans les figures, de mêmes références désignent des couches identiques ou similaires.

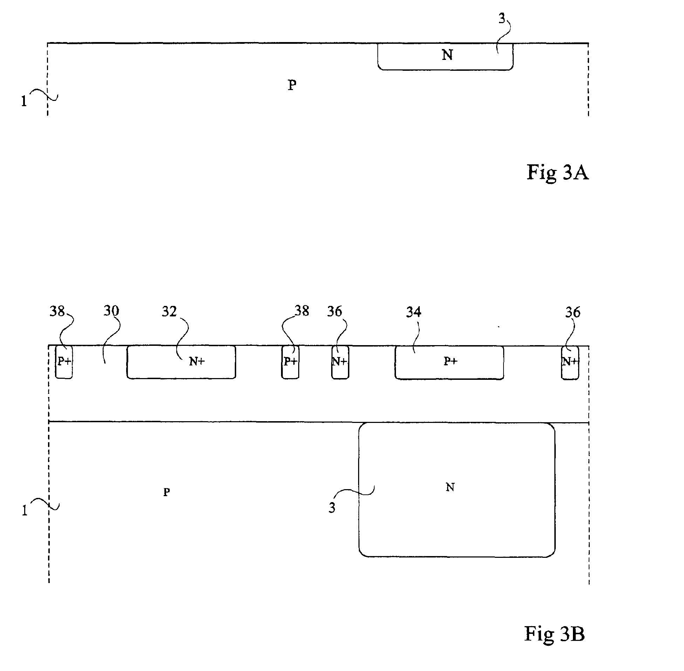

Dans une première étape de réalisation de la présente invention, illustrée en figure 3A, on forme dans un substrat 1 de type P, du côté où l'on voudra former un transistor PNP, une région 3 dopée de type N, couramment par implantation.

Dans les figures suivantes, la partie gauche de la figure correspond à une région dans laquelle on veut former un transistor NPN et la partie droite de la figure à une zone dans laquelle on veut former un transistor PNP.

A une étape suivante illustrée en figure 3B, on développe sur la plaquette une couche épitaxiée faiblement dopée 30. Cette étape d'épitaxie est précédée d'une étape de diffusion et de redistribution des dopants de la couche 3. Du côté du transistor NPN, on forme une région fortement diffusée 32 de type N, qui correspondra au collecteur du transistor NPN. Du côté du transistor PNP on forme une région fortement dopée de type P 34 qui correspondra au collecteur du transistor PNP. En même temps que la région 32 de type N, on forme une région 36 fortement dopée de type N à la périphérie de la région 34. De même, en même temps que l'on forme la région 34 fortement dopée de type P, on forme une région 38 à la périphérie de la couche enterrée de collecteur 32 du transistor NPN.

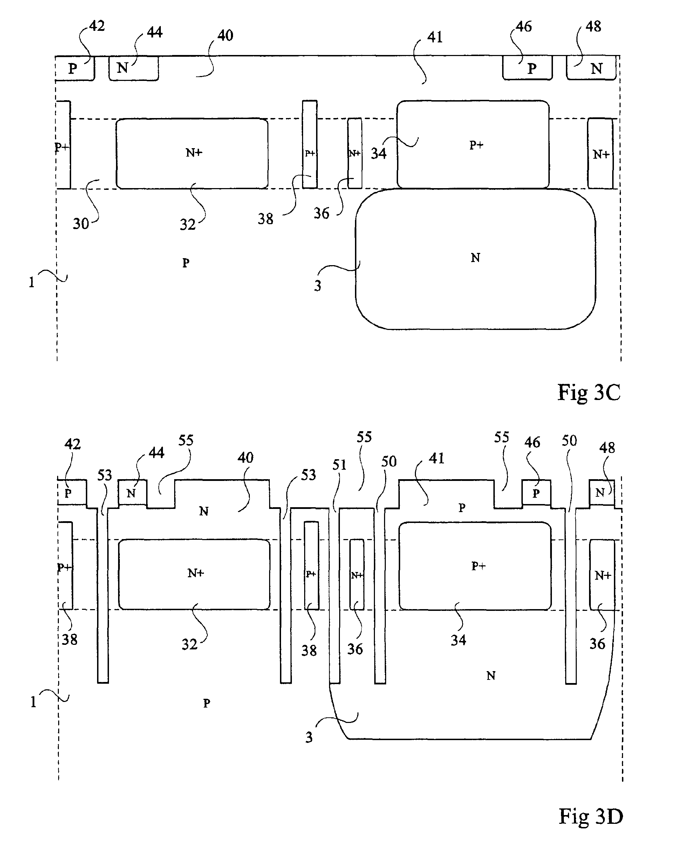

A une étape suivante illustrée en figure 3C, on procède à un recuit thermique pour que les couches 32, 34, 36 et 38 s'étendent en particulier sur toute l'épaisseur de la couche épitaxiée 30. A la suite de cette étape, on notera que la région 34 vient au contact de la région d'isolement sous-jacente 3 du transistor PNP. Par contre, les diffusions latérales des régions 32 à 38 doivent être limitées pour que les dopants de ces diverses régions ne se compensent pas. De préférence, on veillera à ce que les fronts de diffusion ne se rejoignent pas.

Après ces recuits, on procède à une nouvelle étape de dépôt épitaxial pour former une couche épitaxiée désignée par la référence 40 du côté du transistor NPN et par la référence 41 du côté du transistor PNP. Des dopages sont effectués pour que la région 40 soit dopée de type N et la région 41 de type P. On a également illustré des régions fortement dopées formées à partir de la surface supérieure de la couche 40-41, à savoir, une région 42 de type P destinée à venir en contact avec une portion de la couche enterrée 38 pour permettre un contact de polarisation de substrat, une région 44 destinée à rejoindre la couche enterrée 32 et à former un puits collecteur, une région 46 de type P destinée à rejoindre la région 34 et à former un puits collecteur, une région 48 de type N destinée à rejoindre au moins partiellement l'anneau enterré 36 pour le polariser de façon appropriée.

A une étape suivante illustrée en figure 3D, on réalise des tranchées profondes pour séparer latéralement diverses régions du composant. Selon un aspect fondamental de la présente invention, on prévoit une tranchée 50 à la périphérie du transistor PNP, cette tranchée traversant les deux couches épitaxiées 30 et 40 et pénétrant dans le substrat 1. La profondeur de cette tranchée est choisie pour que, après tous les recuits, il y ait continuité de régions dopées de type N entre la région 3 disposée sous le collecteur et l'anneau N⁺ 36 sur lequel un contact est repris par l'intermédiaire d'une région superficielle 48 de type N.

De préférence, il est prévu d'autres tranchées 51, 53, formées en même temps que la tranchée 50 pour délimiter des zones de transistor NPN et de reprise de contact de polarisation du substrat et/ou des zones d'isolement. Les tranchées 51 séparent les couches enterrées 36 et 38. La tranchée 53 sépare le transistor NPN des couches enterrées 38. En outre, on notera sur la figure 3D des tranchées peu profondes 55 formées à partir de la surface pour délimiter diverses régions. Dans une technologie de type BiCMOS, les tranchées 55 pourront être fabriquées "gratuitement" étant donné que des tranchées similaires sont généralement prévues du côté des structures CMOS.

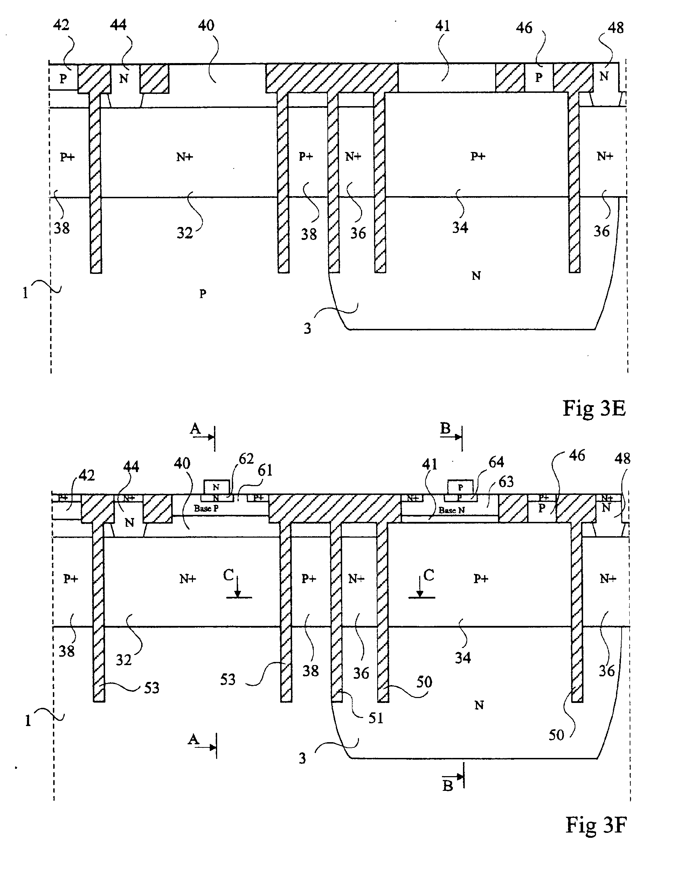

A l'étape de la figure 3E, les tranchées sont remplies. De préférence, on procède d'abord à un recuit pour créer une couche d'oxyde thermique après quoi l'on procède à un remplissage par CVD par exemple de SiO₂ ou de silicium polycristallin. Une étape de planarisation mécano-chimique (CMP) complète et termine éventuellement le processus de réalisation des tranchées isolantes. Au cours de ces étapes, les diverses régions formées précédemment diffusent.

A l'étape illustrée en figure 3F, on forme une région de base 61 et une région d'émetteur 62 dans la couche de type N 40 pour le transistor NPN et une région de base 63 et une région d'émetteur 64 dans la région 41 pour le transistor PNP.

Enfin, on procédera de façon classique aux diverses étapes d'isolement et de réalisation de contacts.

Par rapport au procédé classique décrit en relation avec la figure 1, le procédé selon la présente invention présente notamment deux différences essentielles.

Une première différence est que l'invention prévoit une double épitaxie, les couches enterrées de collecteur des transistors NPN et PNP étant formées à partir de la première épitaxie alors que la couche d'isolement du transistor PNP est formée à partir du substrat avant cette première épitaxie. La deuxième épitaxie correspond en fait à l'unique épitaxie classique.

La réalisation de la première épitaxie entraîne que la couche enterrée de collecteur du transistor PNP ne subit que légèrement l'influence de la diffusion d'isolement de ce même transistor PNP et n'est compensée que de façon négligeable par cette diffusion. Ainsi, pour obtenir une couche enterrée de collecteur de niveau de dopage (et donc de résistance) déterminée, on pourra utiliser une plus faible dose d'implantation que dans le procédé antérieur. Cette couche enterrée remontera donc moins vers le haut en fin de processus. Ceci entraîne que l'épaisseur de la deuxième couche épitaxiée, qui correspond à la seule couche épitaxiée du procédé classique, peut être choisie suffisamment faible pour obtenir un transistor NPN de qualité optimale.

Une deuxième différence entre le procédé de la présente invention et le procédé de l'art antérieur réside dans la prévision des tranchées profondes traversant complètement les deux couches épitaxiées et pénétrant dans le substrat sous-jacent. La présence de ces tranchées permet notamment d'assurer que les régions enterrées de collecteur 32, 34 ont une étendue latérale limitée. Du côté du transistor PNP, la région 36 servant à la reprise de contact avec la région d'isolement 3 peut se trouver très près de cette couche enterrée (la distance étant fixée par l'épaisseur de la tranchée) sans contribuer à une augmentation de capacité entre le collecteur et la couche d'isolement du côté du transistor PNP. Du côté du transistor NPN, les tranchées 53 limitent la capacité latérale entre le collecteur 32 et les couches enterrées de contact de substrat 38.

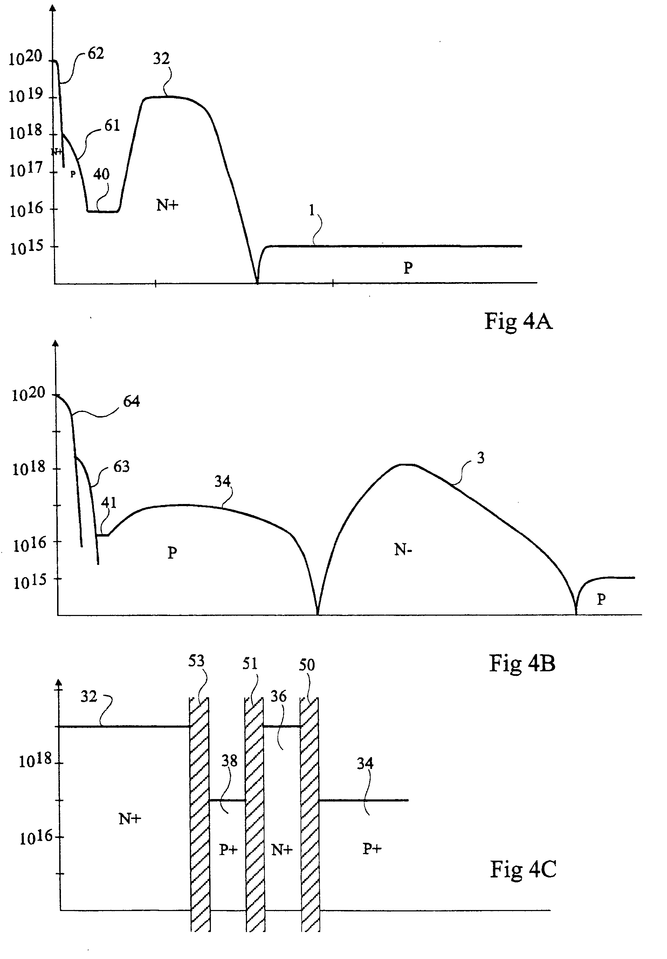

Les caractéristiques d'une structure selon la présente invention sont illustrées en figures 4A-4C prises selon de mêmes plans de coupe que les figures 2A-2C. Dans ces figures, les portions de courbes sont désignées par les références des couches et régions correspondantes. La figure 4A est une vue en coupe selon la ligne A-A de la figure 3F. La figure 4B correspond à une vue en coupe selon la ligne B-B à travers le transistor NPN. La figure 4C correspond à une vue en coupe selon la ligne C-C transversalement à la zone de séparation entre les couches enterrées de collecteur des transistors NPN et PNP.

Il ressort clairement de ces courbes que l'on peut augmenter le niveau de dopage de la région d'isolement 3 de type N sans influer sur le niveau de dopage de la région 34 de collecteur enterré du transistor PNP. Il en ressort comme l'illustre notamment une comparaison des figures 4C et 2C que le dopage effectif des couches 34 et 38 en fin de processus sera seulement identique alors que, dans l'art antérieur, ce dopage effectif était plus faible pour la couche enterrée 4 que pour la région 6 du fait de la compensation par les dopants N de la couche d'isolement 3 dans la couche 4.

Dans un mode de réalisation particulier et pour donner un exemple d'ordre de grandeur, on pourra choisir les données numériques suivantes pour réaliser le procédé :
dopage de l'émetteur 62 : 10¹⁹ à 10²¹ at/cm³
dopage de l'émetteur 64 : 10¹⁹ à 10²¹ at/cm³
dopage de la base P 61 : 10¹⁷ à 10¹⁹ at/cm³
dopage de la base N 64 : 10¹⁷ à 10¹⁹ at/cm³
dopage de la zone d'isolation 3 : 10¹⁶ à 10¹⁹ at/cm³
dopage du collecteur P+ 34 : 10¹⁶ à 10¹⁹ at/cm³
dopage du collecteur N+ 32 : 10¹⁸ à 10²⁰ at/cm³
profondeur de diffusion de la zone 3 : 1 à 6 *µ*m
épaisseur de la première couche épitaxiée : 1 à 5 *µ*m
épaisseur de la deuxième couche épitaxiée : 0,5 à 2 *µ*m
largeur de la tranchée profonde : 0,2 à 2 *µ*m.

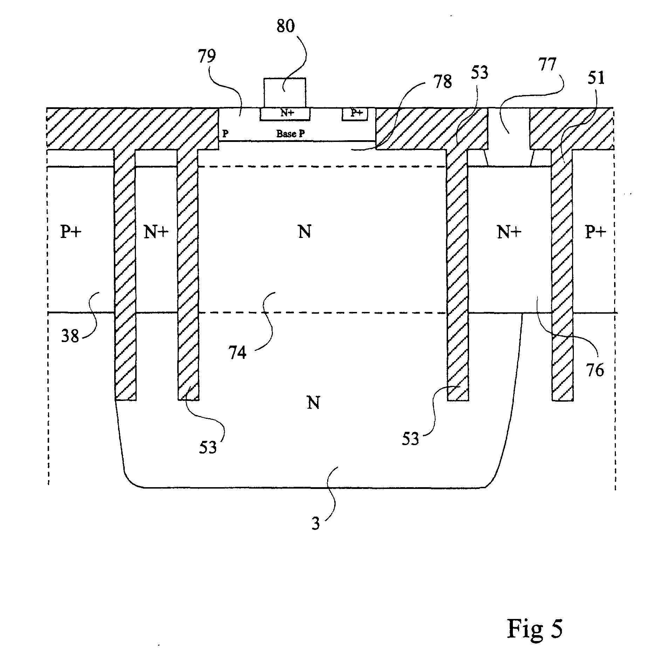

La figure 5 représente une variante de transitor NPN selon l'invention optimisé en tenue en tension. Une région dopée 3 de type N est formée dans le substrat 1. Une région 74 dopée de type N est réalisée dans la première couche de silicium épitaxié. La périphérie de ces régions N 3 et 74 est similaire à la périphérie des régions 3 et 34 précédemment décrites. Elle comporte outre les tranchées profondes, une zone de silicium 76 de type N fortement dopée réalisée dans la première couche épitaxiée et une prise de contact superficielle 77 avec cette zone. Une région 78 dopée de type N dans la deuxième couche épitaxiée termine le collecteur de ce transistor bipolaire.

La structure émetteur-base 79-80 est formée de façon classique à partir de la surface du silicium. Cette structure peut être identique en dopage à celle du transistor NPN décrit précédemment.

Le collecteur de ce transistor bipolaire est constitué des régions 78 et 74 dont le profil de dopage définit la tenue en tension du dispositif. Le contact électrique sur ce collecteur est constitué par les régions 3, 76 et 77. La topologie de ce contact collecteur est très favorable à un bon contrôle du claquage de la jonction base-collecteur du transistor, car le potentiel de la zone 77 n'agit pas, directement, sur le champ électrique dans la zone 78-79.

Bien entendu, la présente invention est susceptible de diverses variantes et modifications qui apparaîtront à l'homme de l'art. Les divers types de conductivité pourront être inversés. Divers moyens pourront être pris pour réaliser les diverses zones dopées. L'homme de l'art pourra choisir les dopants en fonction de son expérience. Par exemple, pour la région 3, il procédera à un dopage au phosphore, pour les couches implantées 34, 38 de type P, à un dopage au bore et pour la couche de collecteur enterré 32 du transistor NPN, à un dopage à l'arsenic.

On n'a pas représenté, dans les diverses figures de vue de dessus. L'homme de l'art choisira les dimensions en fonction des caractéristiques de puissance des divers composants et des possibilités des filières technologiques qu'il utilisera. D'autre part, on a mentionné précédemment des tranchées respectivement situées à la périphérie des transistors NPN et PNP. On notera que dans certaines réalisations, ces tranchées pourront être réalisées sur une partie seulement de la périphérie de l'un au moins de ces transistors.

Par ailleurs, on a décrit ici seulement la réalisation de transistors bipolaires. On notera que, à partir de la structure illustrée en figure 3C, au lieu de continuer le processus pour fabriquer un transistor bipolaire, on pourra continuer le processus pour fabriquer des transistors MOS. Notamment si l'on réalise un transistor MOS à canal N au-dessus de la région P⁺ 34, on aura l'avantage par rapport aux structures classiques que ce transistor MOS présentera une très bonne isolation verticale par rapport au substrat du fait que les couches P⁺ 34 et N 3 peuvent avoir un niveau de dopage librement choisi.

La réalisation de transistors de type MOS complémentaires (CMOS) est aisément adaptable au substrat obtenu pour constituer des circuits de type soit BiCMOS soit purement CMOS. Les valeurs élevées des dopages des couches enterrées, associées à une isolation optionnelle par tranchées profondes, font que ces circuits à base de transistors CMOS peuvent être rendus insensibles aux déclenchements de thyristors parasites inhérents à ce type de circuit et aux signaux électriques parcourant le substrat.

## Revendications

1. Procédé de réalisation d'un transistor bipolaire dans un substrat d'un premier type de conductivité comprenant les étapes suivantes :
former dans le substrat une première zone (3) d'un deuxième type de conductivité ;
former par épitaxie une première couche de silicium (30) ;
former dans cette première couche de silicium, et sensiblement au-dessus de la première zone une deuxième zone (34) fortement dopée, du premier type de conductivité ;
former en périphérie de cette deuxième zone une troisième zone (36) du deuxième type de conductivité, disjointe de la deuxième zone ;
former par épitaxie une deuxième couche de silicium (41) ;
réaliser une tranchée profonde (50) traversant les première et deuxième couches de silicium, pénétrant dans le substrat et séparant latéralement la deuxième zone (34) de la troisième zone (36) ; et
procéder à un recuit tel que le dopant de la troisième zone (36) soit en continuité avec celui de la première zone (3).

2. Procédé selon la revendication 1, dans lequel le premier type de conductivité est le type P et le deuxième type de conductivité est le type N, le transistor réalisé étant un transistor PNP, **caractérisé en ce qu'**il comprend en outre la réalisation d'un transistor de type NPN pour lequel on forme dans la première couche de silicium une région fortement dopée de type N (32), la région correspondant au transistor NPN étant séparée de la région correspondant au transistor PNP par au moins une tranchée.

3. Procédé selon la revendication 2, consistant en outre à former un transistor NPN dont la couche enterrée de collecteur correspond à ladite première zone (3).

4. Transistor bipolaire de type PNP réalisé dans deux couches successives épitaxiées sur un substrat de type P comprenant :
dans sa partie centrale une première zone N (3) diffusée dans le substrat P, une deuxième zone P⁺ (34) réalisée dans la première couche épitaxiée, une structure de base N et d'émetteur P⁺ réalisée dans la deuxième couche épitaxiée ;
une tranchée en anneau (50) creusée dans le silicium, traversant les deux couches épitaxiées et pénétrant dans le substrat, la deuxième zone étant délimitée latéralement par cet anneau, la première zone (3) s'étendant au moins partiellement sous ledit anneau ; et
à l'extérieur de l'anneau, une troisième zone N⁺ (36) réalisée dans la première couche épitaxiée et venant en contact avec la première zone N (3).

5. Transistor bipolaire de type PNP selon la revendication 4, **caractérisé en ce qu'**il comprend une deuxième tranchée (51) traversant les deux couches de silicium épitaxiées et entourant la troisième zone N⁺ (36).

6. Transistor bipolaire de type NPN associé à un transistor bipolaire de type PNP selon la revendication 4, **caractérisé en ce qu'**il comprend :
dans sa partie centrale une même première zone N (3), une quatrième zone N (34) réalisée dans la première couche épitaxiée, une structure de base P (79) et d'émetteur N⁺ (80) réalisée dans la deuxième couche épitaxiée ;
une tranchée en anneau (53) creusée dans le silicium, traversant les deux couches épitaxiées et pénétrant dans le substrat, la quatrième zone (34) étant délimitée latéralement par cet anneau, la première zone (3) s'étendant au moins partiellement sous ledit anneau ; et
à l'extérieur de l'anneau, une troisième zone N⁺ (36) réalisée dans la première couche épitaxiée et venant en contact avec la première zone N (3).
